(19) Europäisches Patentamt

European Patent Office

Office européen des brevets

(11) EP 1 071 127 A2

(12) EUROPEAN PATENT APPLICATION

(43) Date of publication:
24.01.2001 Bulletin 2001/04

(51) Int. Cl.⁷: $H01L\ 21/66$, $G06F\ 17/50$

(21) Application number: 00115658.7

(22) Date of filing: 20.07.2000

(84) Designated Contracting States:
AT BE CH CY DE DK ES FI FR GB GR IE IT LI LU MC NL PT SE
Designated Extension States:
AL LT LV MK RO SI

(30) Priority: 21.07.1999 JP 20652599

(71) Applicant: NEC CORPORATION
Tokyo (JP)

(72) Inventor: Akiyama, Yutaka
Minato-ku, Tokyo (JP)

(74) Representative:
Glawe, Delfs, Moll & Partner
Patentanwälte
Postfach 26 01 62
80058 München (DE)

(54) **High speed simulation method of an oxidation process in a semiconductor device**

(57)    A process simulation method when an oxide film is formed on a surface of a semiconductor material, is attained by (a) setting of a specified film thickness of an oxide film, and a time interval as a time increment; by (b) incrementing a current time by the time increment; by (c) calculating a surface oxidant concentration at the current time using the oxidant diffusion equation: by (d) calculating the effective film thickness of the oxide film at the specified position at the current time from the surface oxidant concentration; by (e) comparing the effective film thickness and the specified film thickness; and by (f) setting the time increment to a half of the time interval, when the effective film thickness is larger than the specified film thickness. The process simulation method may further include: (g) repeating the steps (b) to (e). Also, the process simulation method may further include: (h) carrying out oxidation reaction rate calculation, production of a new boundary and a deformation calculation, when the effective film thickness is not larger than the specified film thickness.

Fig. 2

EP 1 071 127 A2

**Description**

**Background of the Invention**

1. Field of the Invention

The present invention relates to a process simulation method, and more particularly, to a high speed process simulation method in which an oxidation process is simulated in a manufacturing process of a semiconductor devices such as an LSI.

2. Description of the Related Art

Conventionally, processes such as an oxidation process, a diffusion process, and an ion implantation process in a manufacturing process of an LSI are calculated by use of a process simulator. Through the above calculation, the process simulator estimates the internal physical quantity and shape of an impurity profile and so on of a semiconductor device.

If the optimization of a transistor is carried out for the semiconductor device to show the best electric characteristic using this process simulator, the large reduction of expense and the shortening of a design period are expected, as compared with a case that an LSI actually experimentally produced.

In the process simulator, because various semiconductor transistor manufacturing processes are calculated using a computer, a model equation is incorporated for every each process. In the LSI, a device separation is carried out by use of a LOCOS film, trench and so on such that a device does not have an electrical influence on another device. The device separation simulation of the LOCOS film, trench and so on becomes necessary with the miniaturization of the device in recent years so that the 2-dimensional process simulation is carried out forward.

As the method of calculating the 2-dimensional LOCOS oxidation, there is known "Semiconductor Process Device Simulation Technique" by S. ISOMAE (published by Realize Company, the first volume "process"; the second chapter, "process simulation", the third paragraph, "Simulation of 2-dimension oxidation", pp. 79-89).

In this way, an oxidation rate is calculated from an oxidant concentration, and how much a $Si/SiO_2$ interface moves in a time interval is calculated. Also, the change of a shape is calculated from the change quantity. In the LOCOS film, an oxidation time is controlled based on the film thickness of the LOCOS oxide film on a center portion. Therefore, in the process simulator, the film thickness of the LOCOS oxide film is specified by a user and the oxidation calculation needs to be carried out such that the film thickness becomes the specified film thickness.

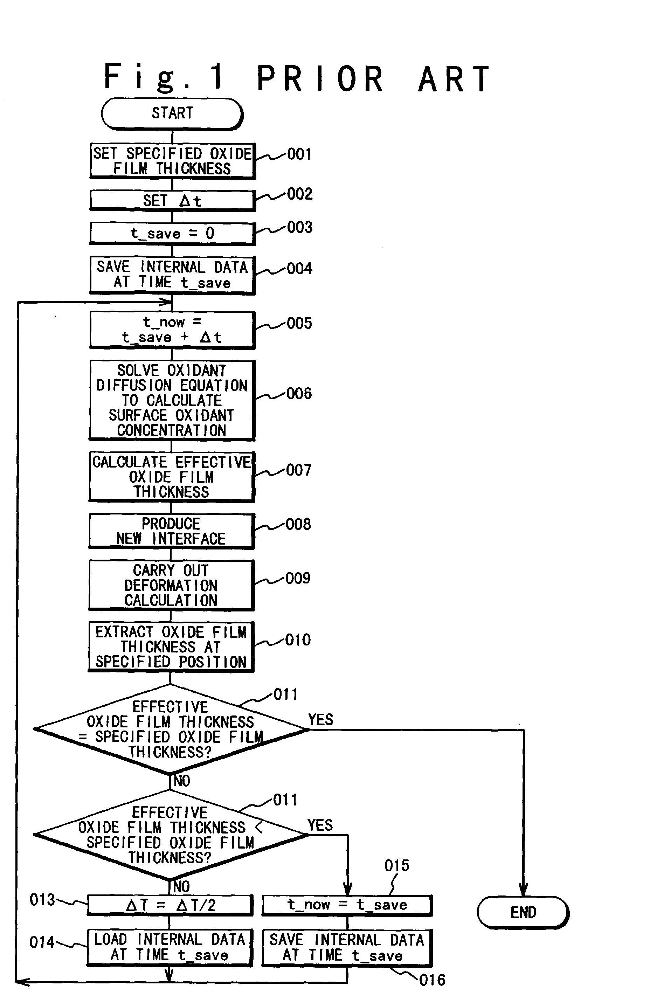

A conventional method will be described with reference to Fig. 1. Fig. 1 is a flow chart showing a process flow of controlling the film thickness of an oxide film in the conventional method. In the conventional method, the oxidation calculation time is adjusted in such a manner that a desired film thickness Tox_target of the LOCOS oxide film is specified by the user, and the film thickness Tox of the LOCOS oxide film extracted as the result of the oxidation calculation is equal to the desired film thickness Tox_target of the oxide film.

Referring to Fig. 1, first, the user sets a desired film thickness Tox_target of a LOCOS oxide film (001). The time interval Δt when the oxidation calculation is carried out is set (002). An initial time is set to t_save=0 (003), and an internal data at t=t_save is stored (004). The storage of the internal data is necessary to abandon a calculation result and then to carry out the calculation once more after the time interval Δt is adjusted when the LOCOS film thickness after oxidation calculation is thicker than the desired film thickness of the oxide film.

Next, a current time is advanced to time t_now=t_save+Δt (005). An oxidant diffusion equation is solved and a surface oxidant concentration Cox in the oxidized interface is calculated (006). Then, an oxidation reaction rate Vox=dTox/dt=K*Cox is calculated from the surface oxidant concentration (007).

The interface before the oxidation moves at the oxidation reaction rate Vox. Therefore, a new interface after the oxidation is calculated by multiplying the oxidation time interval Δt (008).

A deformation calculation is carried out based on the stress which is generated from the volume ratio m of a silicon film and the oxide film (009), and then an film thickness of the oxide film at the specified position is extracted (010).

It is determined whether or not the extracted film thickness Tox of the oxide film is equal to the specified film thickness Tox_target (011). When both are equal to each other, the oxidation calculation is ended. When the extracted film thickness Tox of the oxide film is thicker than the specified film thickness Tox_target, the time interval Δt is decreased to 1/2 (013). Then, the internal data which has been stored previously is loaded (014), and then the flow returns to (005). Thereafter, the above procedure above is repeated.

On the other hand, when the extracted film thickness Tox of the oxide film is thinner than the specified film thickness Tox_target, the current time t_now is set to the previous time t_save (015). Then, the internal data which is necessary for the oxidation calculation is stored (016), and the flow returns to the step (005). Thereafter, the above procedure is repeated.

According to the above conventional method, it is always necessary to carry out the deformation calculation to extract the film thickness of the oxide film in the specified position. Therefore, when the extracted film thickness of the oxide film is thicker than the specified film thickness, unnecessary deformation calculation is carried out. Therefore, the long calculating time is taken. Also, when the extracted film thickness of the oxide film is thicker than the specified film thickness of the oxide film, the result of the deformation calculation calculated for every time interval is abandoned. Therefore, the internal data at the previous time needs to be store previously.

In addition, other conventional techniques are is simply described. A film thickness simulation algorithm of a silicon oxide film is disclosed in Japanese Laid Open Patent Application (JP-A-Heisei 8-55145) to provide a device structure data as similar to the actually device structure as possible. In this reference, there are provided a process executing means for forming an actual silicon oxide film in accordance with a process condition, a film thickness detecting means for detecting the film thickness of the formed silicon oxide film, a process simulation means for executing an oxidation calculation algorithm in accordance with the process condition, a comparing means for comparing the measurement value of the film thickness of the silicon oxide film and the calculation value, and an oxide film growth speed changing means for changing the oxide film growth rate of the process simulation means such that the detected film thickness of the silicon oxide film is equal to the film thickness of the silicon oxide film calculated in accordance with the comparing result. The oxide film growth rate is changed until the calculation value of the film thickness of the silicon oxide film is coincident with the detected value.

In Japanese Laid Open Patent Application (JP-A-Heisei 8-236516) is disclosed a simulation method of the oxide film shape of a semiconductor device in a semiconductor manufacture process in which the oxide film shape formed after a silicon film is oxidized is simulated. In this reference, the oxide film shape formed after the silicon film is oxidized is simulated based on an oxidation model of Deal-Grove and the deformation of the device which is accompanied by the oxidation is simulated using a viscosity fluid model of Chin. Predetermined values are used as viscosity coefficients of the oxide film and nitride film, a parameter Vd which determines a diffusion coefficient of oxidation species, a parameter Vr which determines the reaction percentage of the oxidation species at the oxide film/silicon interface, and a parameter Vc which determines a viscosity coefficient.

In Japanese Laid Open Patent Application (JP-A-Heisei 10-303192) is disclosed that effective surface oxidant concentration is calculated in consideration of a natural oxide film which is inevitably formed when the oxidized surface is exposed, in the area where the oxidized surface of the silicon film is coming in touch with an oxidation atmosphere, so that the operability and the convenience of the oxidation simulator are improved.

In Japanese Laid Open Patent Application (JP-A-Heisei 11-40561) is appropriately determined the time process of oxidant diffusion in an oxide film in an oxidation process even when each device of the semiconductor device has an optional shape. In this method, an oxidant concentration CSOX at the interface between the oxide film and a silicon substrate obtained by solving a 2-dimensional Laplace equation of the oxidant diffusion is substituted into a (1) equation. The film thicknesses TEOX of the effective oxide film is found at all of the plurality of nodes which are previously set on the interface between the oxide film and the silicon substrate, and then the time process $\Delta t$ is found from the minimum value TMOX of the calculated film thicknesses TEox and a desired increment $\Delta$ TOX of the film thickness of the oxide film per the time process $\Delta t$.

## Summary of the Invention

Therefore, an object of the present invention is to provide a new process simulation in which the effective film thickness of an oxide film is extracted from the surface oxidant concentration when 2-dimension oxidation is carried for a specified film thickness.

Another object of the present invention is to provide a new process simulation in which the oxidation calculation can be speeded up without unnecessary deformation calculation.

In an aspect of the present invention, a process simulation method when an oxide film is formed on a surface of a semiconductor material, is attained by (a) setting of a specified film thickness of an oxide film, and a time interval as a time increment; by (b) incrementing a current time by the time increment; by (c) calculating a surface oxidant concentration at the current time using the oxidant diffusion equation; by (d) calculating the effective film thickness of the oxide film at the specified position at the current time from the surface oxidant concentration; by (e) comparing the effective film thickness and the specified film thickness; and by (f) setting the time increment to a half of the time interval, when the effective film thickness is larger than the specified film thickness. The process simulation method may further include: (g) repeating the steps (b) to (e).

Also, the process simulation method may further include: (h) carrying out oxidation reaction rate calculation, production of a new boundary and a deformation calculation, when the effective film thickness is not larger than the specified film thickness.

In this case, the process simulation method may further include: (i) repeating the steps (b) to (e), when the effective film thickness is smaller than the specified film thickness.

Also, the process simulation method may further include: (j) determining whether a first mode is set, after the step (c). Oxidation calculation is carried out in the first mode such that the effective film thickness is nearly equal to the specified film thickness. The step (a) further includes: setting the first mode, and the step (d) is carried out when it is determined at the step (j) that the first mode is set.

In this case, the process simulation method may further include: (k) carrying out oxidation reaction rate calculation, production of a new boundary and a deformation calculation, when the effective film thickness is not larger than the specified film thickness or when it is determined at the step (j) that the first mode is not set; and (l) extracting a film thickness of the oxide film at the specified position at the current time.

Also, the process simulation method may further include: (m) comparing the extracted film thickness and the specified film thickness; (n) setting a second mode in place of the first mode such that the film thickness of the oxide film is extracted at the specified position at the current time, when the extracted film thickness is larger than the specified film thickness; (o) setting the time increment to the half of the time interval; (p) loading internal data at a time before the current time by the time increment; and (q) carrying out the step (b).

Also, the process simulation method may further include: (r) saving internal data at the current time; and (s) carrying out the step (b).

Also, the effective film thickness of the oxide film is a summation of an film thickness of the oxide film calculated from the oxidant concentration:

$$A/2*(h/(h+k)*C{\sim}-Cox)/Cox$$

and an increment of the film thickness of the oxide film during the time increment:

$$K*Cox*\Delta t/m.$$

where A, h, k and K are proportional constant values, $C{\sim}$ is an oxidant equilibrium concentration, Cox is the surface oxidant concentration, $\Delta t$ is the time interval, and m is a ratio in a volume density of a silicon film and a silicon oxide film.

In order to achieve another aspect of the present invention, a simulator for simulating an oxide film formed on a surface of a semiconductor material, includes: an input unit, a display unit and a process. The input unit is used to input a specified film thickness of an oxide film, and a time interval as a time increment. The processor which carries out: (a) setting of the specified film thickness of the oxide film, and the time interval as a time increment; (b) incrementing a current time by the time increment; (c) calculating a surface oxidant concentration at the current time using the oxidant diffusion equation; (d) calculating the effective film thickness of the oxide film at the specified position at the current time from the surface oxidant concentration; (e) comparing the effective film thickness and the specified film thickness; and (f) setting the time increment to a half of the time interval, when the effective film thickness is larger than the specified film thickness.

The processor repeats the operations (b) to (e). Also, the processor carries out oxidation reaction rate calculation, production of a new boundary and a deformation calculation, when the effective film thickness is not larger than the specified film thickness.

In this case, the processor may repeat the operations (b) to (e), when the effective film thickness is smaller than the specified film thickness. Also, the processor may: set the first mode at the operation (a) wherein oxidation calculation is carried out in the first mode such that the effective film thickness is nearly equal to the specified film thickness; and (j) determine whether the first mode is set, after the operation (c), wherein the operation (d) is carried out when it is determined at the operation (j) that the first mode is set.

Also, the processor carries out oxidation reaction rate calculation, production of a new boundary and a deformation calculation, when the effective film thickness is not larger than the specified film thickness or when it is determined at the operation (j) that the first mode is not set, and extracts a film thickness of the oxide film at the specified position at the current time.

In this case, the processor compares the extracted film thickness and the specified film thickness; sets a second mode in place of the first mode such that the film thickness of the oxide film is extracted at the specified position at the current time, when the extracted film thickness is larger than the specified film thickness; sets the time increment to the half of the time interval; loads internal data at a time before the current time by the time increment; and carries out the operation (b). Also, the processor: saves internal data at the current time; and carries out the operation (b).

Also, the effective film thickness of the oxide film is a summation of an film thickness of the oxide film calculated from the oxidant concentration:

$$A/2*(h/(h+k)*C{\sim}-Cox)/Cox$$

and an increment of the film thickness of the oxide film during the time increment:

$$K*Cox*\Delta t/m.$$

where A, h, k and K are proportional constant values, C~ is an oxidant equilibrium concentration, Cox is the surface oxidant concentration, $\Delta t$ is the time interval, and m is a ratio in a volume density of a silicon film and a silicon oxide film.

In order to achieve still another aspect of the present invention, a recording medium storing a program for a process simulation method when an oxide film is formed on a surface of a semiconductor material. Here, the process simulation method includes: (a) setting of a specified film thickness of an oxide film, and a time interval as a time increment; (b) incrementing a current time by the time increment; (c) calculating a surface oxidant concentration at the current time using the oxidant diffusion equation; (d) calculating the effective film thickness of the oxide film at the specified position at the current time from the surface oxidant concentration; (e) comparing the effective film thickness and the specified film thickness; and (f) setting the time increment to a half of the time interval, when the effective film thickness is larger than the specified film thickness.

**Brief Description of the Drawings**

Fig. 1 is a flow chart showing a conventional process simulation method;
Fig. 2 is a flow chart showing a process simulation method according to a first embodiment of the present invention;
Fig. 3 is a diagram showing the operation in the first embodiment;
Fig. 4 is a flow chart showing the process simulation method according to a second embodiment of the present invention;
Fig. 5 is a diagram showing the adjustment of an oxidation calculation time in case of LOCOS calculation; and
Fig. 6 is a block diagram showing the process simulator of the present invention.

**Description of the Preferred Embodiments**

A process simulation of the present invention will be described below in detail with reference to the attached drawings.

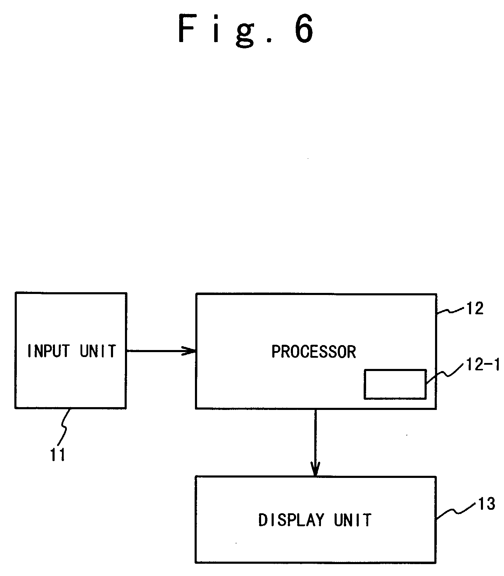

Fig. 6 shows a process simulator of the present invention. The process simulator is composed of an input unit 11, a processor 12 with a memory 12-1 and a display unit 13. The processor 12 executes a program for a process simulation method which is stored in a recording medium. An initial condition is inputted from the input unit 11 to the processor 12 and stored in the memory 12-1. The processor 12 carries out the process simulation based on the program and displays the simulation result on the display unit 13.

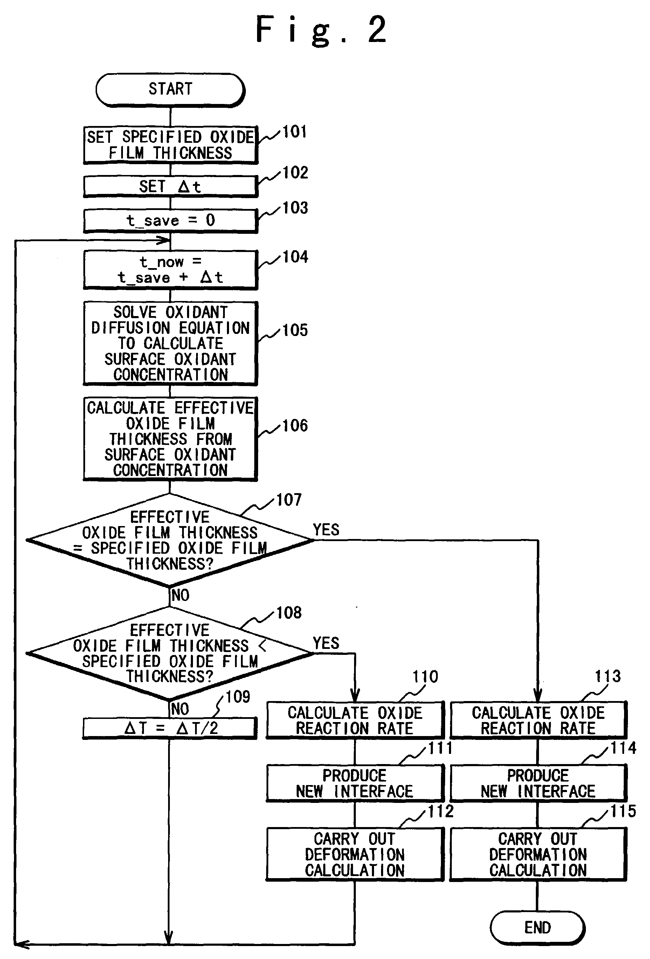

Fig. 2 is a flow chart of the process simulation method according to the first embodiment of the present invention. Referring to Fig. 2, first, a desired specified film thickness Tox_target of an oxide film is set at a step (101). A time interval $\Delta t$ when the oxidation calculation is carried out is set at a step (102), and an initial time is set to t_save=0 at a step (103).

Next, the current time is advanced to a time t_now=t_save+$\Delta t$ (104). An oxidant diffusion equation is solved such that a surface oxidant concentration Cox in the oxidized interface is calculated (105).

Next, an effective film thickness of the oxide film in a specified position is calculated from the surface oxidant concentration Cox (106). The effective film thickness Tox_eff of the oxide film can be expressed as a summation of the film thickness of the oxide film at the previous time t_save which can be calculated from the oxidant concentration: $A/2*(h/(h+k)*C{\sim}-Cox)/Cox$, and an increment of the film thickness of the oxide film for the time interval $\Delta t$: $K*Cox*\Delta t/m$, where A, K, h, k are proportional constants, C~ is an oxidant equilibrium concentration, and m is a volume density ratio of the silicon film and the oxide film.

When the effective film thickness Tox_eff of the oxide film is compared with the specified film thickness Tox_target (107). When both are coincident with each other, the oxidation reaction rate calculation (113), the production of a new interface (114), and the deformation calculation (115) are carried out and then a flow is ended. The simulation result is displayed on a display unit 13.

When the effective film thickness Tox_eff of the oxide film is thicker than the specified film thickness Tox_target, the time interval $\Delta t$ is decreased to $(1/2)\Delta t$ (109). At this time, the flow returns to (104) without carrying out the deformation calculation, and then the above procedure is repeated.

When the effective film thickness of the oxide film is thinner than the specified film thickness, the oxidation reaction rate calculation (110), the production of the new interface (111), and the deformation calculation (112) are carried out and the flow returns to (104), and then the above procedure is repeated.

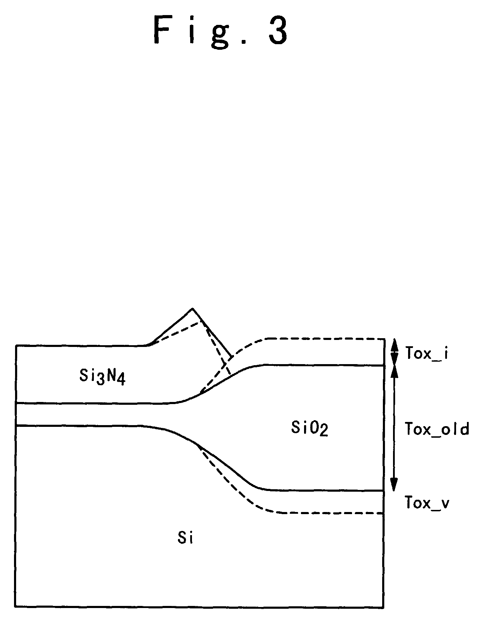

Fig. 3 shows the operation of the process simulation method in the first embodiment.

In the shape before the deformation (the shape at a previous time t_save: solid line), when the oxidant diffusion equation is solved, the oxidant concentration at the interface between the $SiO_2$ film and the Si film can be calculated. At the end of the LOCOS film, the film thickness Tox_old of the oxide film at the previous time t_save can be calculated from the following equation based on the oxidant concentration using the 1-dimensional equation of Deal-Grove:

$$Tox\_old=A/2*(h/(h+k)*C\sim-Cox)/Cox$$

where A, K, h, and k are proportional constants and $C\sim$ is an equilibrium concentration of oxidant.

Also, the increment of the film thickness of the oxide film for the time interval $\Delta t$ can be expressed as a summation of a thickness Tox_v when the Si film is changed into the $SiO_2$ film through the oxidation and the film thickness Tox_i of the oxide film which is increased at the volume density ratio of Si and $SiO_2$. Therefore, the increment of the film thickness of the oxide film is possible to calculate from

$$Tox\_v+Tox\_i=K*Cox*\Delta t/m$$

where m is the volume density ratio of Si and $SiO_2$.

In this way, the effective film thickness Tox_eff of the oxide film at the current time t_new can be expressed as follow:

$$Tox\_eff=A/2*(h/(h+k)*C\sim-Cox)/Cox + K*Cox*\Delta t/m$$

The effective film thickness of the oxide film is extracted from the surface oxidant concentration, and it is possible to speed up the oxidation calculation while omitting unnecessary deformation calculation.

The effect of the above embodiment is in that the speeding-up of the oxidation calculation becomes possible while omitting the unnecessary deformation calculation when the effective film thickness of the oxide film is thicker than the specified film thickness.

Next, the process simulation method according to the second embodiment of the present invention will be described.

The above-mentioned first embodiment is effective when the field section of LOCOS is wide sufficiently and the end of the LOCOS film can be assumed as the 1-dimensional shape. However, there is a case where the LOCOS film thickness can not be correctly calculated from the oxidant concentration when the field section is narrow.

In the process simulation according to the second embodiment of the present invention, two modes (mode=0 and mode=1) are employed. In the first mode (mode=0), the oxidation calculation is carried out such that the film thickness becomes approximately equal to the specified film thickness of oxide film, using the effective film thickness of the oxide film determined from the oxidant concentration. On the other hand, in the second mode (mode=1), an film thickness of the oxide film in the specified position is extracted through the deformation calculation. Thus, even when the end of the LOCOS film can not be regarded as the 1-dimensional shape, the method of speeding-up the oxidation calculation is shown by omitting unnecessary deformation calculation.

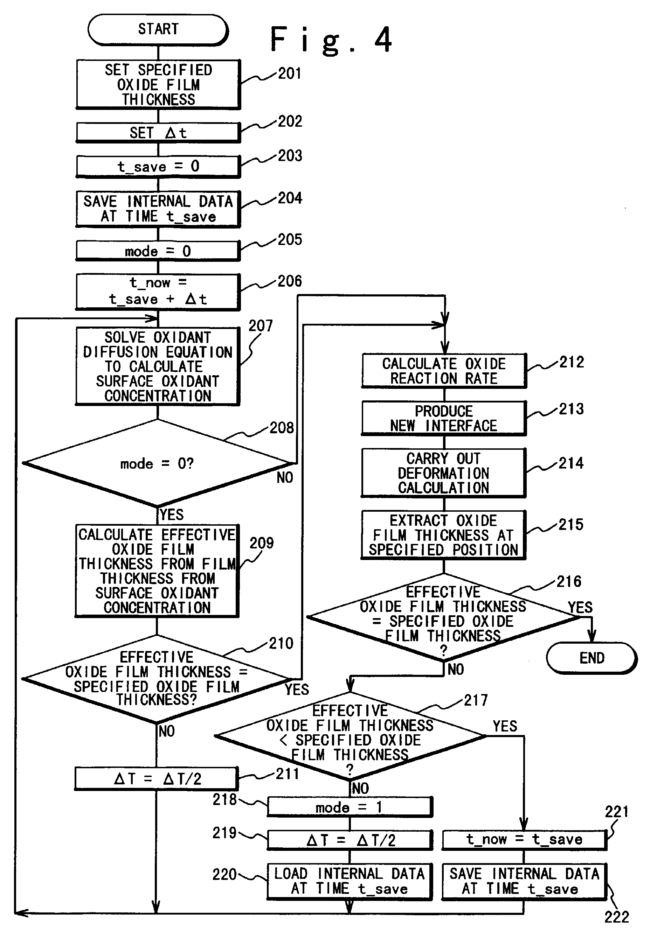

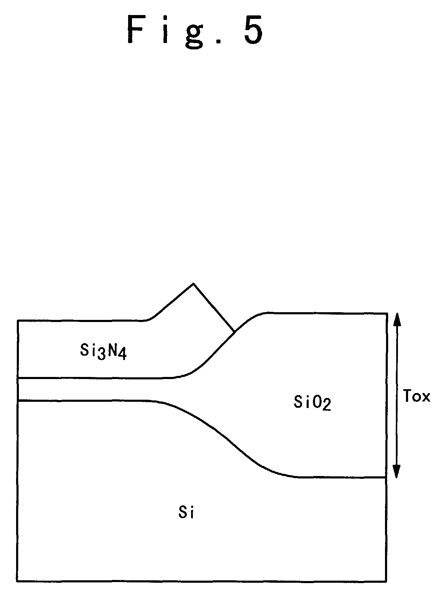

Fig. 4 shows a flow chart of the process simulation method according to the second embodiment of the present invention. Fig. 5 shows the operation of the process simulation according to the second embodiment of the present invention.

Referring to Fig. 4, first, a desired film thickness Tox_target of the oxide film is set in (201) and the time interval $\Delta t$ when oxidation calculation is carried out is set (202). Also, an initial time is set to t_save=0 in (203) and the internal data at time t=t_save is stored (204). A mode is set to the first mode (mode=0) to find the oxidation time after which the film thickness becomes approximately equal to the specified film thickness of the oxide film (205).

Next, a current time is advanced to time t_now=t_save+$\Delta t$ (206). An oxidant diffusion equation is solved and a surface oxidant concentration Cox in the oxidized interface is calculated (207).

The mode is determined (208). In case of mode=0, the effective film thickness of the oxide film in the specified position is calculated from the surface oxidant concentration Cox (209) like the above first embodiment. In case of mode=1, the oxidation reaction rate calculation (212) is carried out.

Next, the effective film thickness Tox_eff of the oxide film is compared with the specified film thickness Tox_target (210). When the effective film thickness Tox_eff of the oxide film is thicker than the specified film thickness Tox_target, the time interval $\Delta t$ is decreased to (1/2)$\Delta t$ (211). At this time, the flow returns to (206) without carrying out the deformation calculation and the above procedure is repeated.

When the effective film thickness Tox_eff of the oxide film is thinner than the specified film thickness that, the oxidation reaction rate calculation (212), the production of a new interface (213), and the deformation calculation (214) are carried out. Thus, the film thickness of the oxide film Tox_extract in the specified position is extracted (215).

Also, the specified film thickness Tox_target and the extracted film thickness Tox_extract of the oxide film are compared (216). When both are coincident with each other, the flow is ended. The simulation result is displayed on a display unit 13.

When the extracted film thickness Tox_extract of the oxide film is thicker than the specified film thickness Tox_target, the mode is set to the second mode (mode=1) in (218). Thus, the mode is switched such that the film thickness of the oxide film in the specified position can be extracted through the deformation calculation. The time interval $\Delta t$ is decreased to $(1/2)\Delta t$ (219), and the internal data which has been stored previously is loaded (220). Then, the flow returns to (206), and the above procedure is repeated.

On the other hand, when it is determined that the extracted film thickness Tox_extract of the oxide film is thinner than the specified film thickness Tox_target (217), the current time t_now is set to the previous time t_save (221). Then, the internal data which is necessary for the oxidation calculation is stored (222), and then the flow returns to (206). Thus, the above procedure is repeated.

In the process simulation method of the present invention, an oxidant diffusion equation is solved in the shape before the deformation, (the shape at a previous time t_save), and an oxidant concentration at the $SiO_2/Si$ interface can be calculated.

A film thickness of the oxide film Tox_old at the end of the LOCOS film at the previous time t_save can be calculated from the oxidant concentration using the 1-dimensional equation of Deal-Grove:

$$Tox\_old = A/2*(h/(h+k)*C\sim -Cox)/Cox$$

where A, K, h, and k are proportional constants, and $C\sim$ is an equilibrium concentration.

Also, the increment of the film thickness of the oxide film for $\Delta t$ is summation of an increment Tox_v when Si is changed into $SiO_2$ through the oxidation and the film thickness Tox_i of the oxide film which increases in the volume density ratio of Si and $SiO_2$. Therefore, the increment of the film thickness of the oxide film is possible to calculate from

$$Tox\_v + Tox\_i = K*Cox*\Delta t/m$$

where m is a the volume density ratio of Si and $SiO_2$.

Therefore, the effective film thickness Tox_eff of the oxide film at the current time t_new can be expressed by:

$$Tox\_eff = A/2*(h/(h+k)*C\sim -Cox)/Cox + K*Cox*\Delta t/m$$

In this way, the effective film thickness of the oxide film is extracted from the surface oxidant concentration in this method, it is possible to speed up the oxidation calculation while eliminating wasteful deformation calculation.

Thus, in the above embodiments, it becomes possible to speed up the oxidation calculation by omitting unnecessary deformation calculation when the effective film thickness of the oxide film is thicker than the specified film thickness.

In this embodiment, in case that the oxidation calculation for the specified film thickness of the oxide film is carried out, the mode is switched between the first mode (mode=0) and the second mode (mode=1). In the first mode (mode=0), the oxidation calculation is carried out such that the film thickness becomes approximately equal to the specified film thickness of the oxide film. Also, in the second mode (mode=1), the film thickness of the oxide film in the specified position is correctly extracted through the deformation calculation. Therefore, the speeding-up of the oxidation calculation can be attained by omitting unnecessary deformation calculation in the first mode (mode=0) in which the calculation for the specified film thickness of the oxide film is carried out.

**Claims**

1. A process simulation method when an oxide film is formed on a surface of a semiconductor material, comprising:

   (a) setting of a specified film thickness of an oxide film, and a time interval as a time increment;
   (b) incrementing a current time by said time increment;
   (c) calculating a surface oxidant concentration at said current time using said oxidant diffusion equation;
   (d) calculating said effective film thickness of said oxide film at said specified position at said current time from said surface oxidant concentration;
   (e) comparing said effective film thickness and said specified film thickness; and
   (f) setting said time increment to a half of said time interval, when said effective film thickness is larger than said specified film thickness.

2. The process simulation method according to claim 1, further comprising:

   (g) repeating said steps (b) to (e).

3. The process simulation method according to claim 1 or 2, further comprising:

   (h) carrying out oxidation reaction rate calculation, production of a new boundary and a deformation calculation, when said effective film thickness is not larger than said specified film thickness.

4. The process simulation method according to claim 3, further comprising:

   (i) repeating said steps (b) to (e), when said effective film thickness is smaller than said specified film thickness.

5. The process simulation method according to claim 3, further comprising:

   (j) determining whether a first mode is set, after said step (c), wherein oxidation calculation is carried out in said first mode such that said effective film thickness is nearly equal to said specified film thickness,
   wherein said step (a) further includes:
   setting said first mode,
   wherein said step (d) is carried out when it is determined at said step (j) that said first mode is set.

6. The process simulation method according to claim 5, further comprising:

   (k) carrying out oxidation reaction rate calculation, production of a new boundary and a deformation calculation, when said effective film thickness is not larger than said specified film thickness or when it is determined at said step (j) that said first mode is not set; and
   (l) extracting a film thickness of said oxide film at said specified position at said current time.

7. The process simulation method according to claim 6, further comprising:

   (m) comparing said extracted film thickness and said specified film thickness;
   (n) setting a second mode in place of said first mode such that the film thickness of said oxide film is extracted at said specified position at said current time, when said extracted film thickness is larger than said specified film thickness;
   (o) setting said time increment to the half of said time interval;
   (p) lading internal data at a time before said current time by said time increment; and
   (q) carrying out said step (b).

8. The process simulation method according to claim 6, further comprising:

   (r) saving internal data at said current time; and
   (s) carrying out said step (b).

9. The process simulation method according to any of claims 1 to 8, wherein said effective film thickness of said oxide film is a summation of an film thickness of the oxide film calculated from the oxidant concentration:

$$A/2*(h/(h+k)*C{\sim}-Cox)/Cox$$

and an increment of the film thickness of said oxide film during the time increment:

$$K*Cox*\Delta t/m.$$

where A, h, k and K are proportional constant values, $C{\sim}$ is an oxidant equilibrium concentration, Cox is said surface oxidant concentration, $\Delta t$ is said time interval, and m is a ratio in a volume density of a silicon film and a silicon oxide film.

**10.** A recording medium which stores a program for said process simulation method according to any of claims 1 to 9.

**11.** A simulator for simulating an oxide film formed on a surface of a semiconductor material, comprising:

an input unit used to input a specified film thickness of an oxide film, and a time interval as a time increment;
a display unit; and
a processor which carries out:

(a) setting of said specified film thickness of said oxide film, and said time interval as a time increment;
(b) incrementing a current time by said time increment;
(c) calculating a surface oxidant concentration at said current time using said oxidant diffusion equation;
(d) calculating said effective film thickness of said oxide film at said specified position at said current time from said surface oxidant concentration;
(e) comparing said effective film thickness and said specified film thickness;
(f) setting said time increment to a half of said time interval, when said effective film thickness is larger than said specified film thickness and
displaying the simulation result on said display unit.

**12.** The simulator according to claim 11, wherein said processor repeats said operations (b) to (e).

**13.** The simulator according to claim 11 or 12, wherein said processor carries out oxidation reaction rate calculation, production of a new boundary and a deformation calculation, when said effective film thickness is not larger than said specified film thickness.

**14.** The simulator according to claim 13, wherein said processor repeats said operations (b) to (e), when said effective film thickness is smaller than said specified film thickness.

**15.** The simulator according to claim 13, wherein said processor:

sets said first mode at said operation (a) wherein oxidation calculation is carried out in said first mode such that said effective film thickness is nearly equal to said specified film thickness;
(j) determining whether said first mode is set, after said operation (c), wherein said operation (d) is carried out when it is determined at said operation (j) that said first mode is set.

**16.** The simulator according to claim 15, wherein said processor:

carries out oxidation reaction rate calculation, production of a new boundary and a deformation calculation, when said effective film thickness is not larger than said specified film thickness or when it is determined at said operation (j) that said first mode is not set; and
extracts a film thickness of said oxide film at said specified position at said current time.

**17.** The simulator according to claim 16, wherein said processor:

compares said extracted film thickness and said specified film thickness;
sets a second mode in place of said first mode such that the film thickness of said oxide film is extracted at said specified position at said current time, when said extracted film thickness is larger than said specified film thickness;
sets said time increment to the half of said time interval;
loads internal data at a time before said current time by said time increment; and
carries out said operation (b).

**18.** The simulator according to claim 16, wherein said processor:

saves internal data at said current time; and
carries out said operation (b).

**19.** The simulator according to any of claims 11 to 18, wherein said effective film thickness of said oxide film is a summation of an film thickness of the oxide film calculated from the oxidant concentration:

$$A/2*(h/(h+k)*C{\sim}-Cox)/Cox$$

and an increment of the film thickness of said oxide film during the time increment:

$$K*Cox*\Delta t/m.$$

where A, h, k and K are proportional constant values, $C\sim$ is an oxidant equilibrium concentration, Cox is said surface oxidant concentration, $\Delta t$ is said time interval, and m is a ratio in a volume density of a silicon film and a silicon oxide film.

# Fig. 1  PRIOR ART

```
         ┌──────────────┐
         │    START     │
         └──────┬───────┘
                │
   ┌────────────────────────┐
   │ SET SPECIFIED OXIDE    │── 001
   │    FILM THICKNESS      │
   └────────────┬───────────┘
                │
   ┌────────────────────────┐
   │        SET Δt          │── 002
   └────────────┬───────────┘
                │
   ┌────────────────────────┐
   │     t_save = 0         │── 003
   └────────────┬───────────┘
                │
   ┌────────────────────────┐
   │  SAVE INTERNAL DATA    │── 004
   │    AT TIME t_save      │
   └────────────┬───────────┘
                │
   ┌────────────────────────┐
   │       t_now =          │── 005
   │    t_save + Δt         │
   └────────────┬───────────┘
                │
   ┌────────────────────────┐
   │    SOLVE OXIDANT       │
   │ DIFFUSION EQUATION     │
   │     TO CALCULATE       │── 006
   │   SURFACE OXIDANT      │
   │    CONCENTRATION       │
   └────────────┬───────────┘
                │
   ┌────────────────────────┐
   │ CALCULATE EFFECTIVE    │── 007
   │     OXIDE FILM         │
   │      THICKNESS         │
   └────────────┬───────────┘
                │
   ┌────────────────────────┐
   │       PRODUCE          │── 008
   │    NEW INTERFACE       │
   └────────────┬───────────┘
                │
   ┌────────────────────────┐
   │     CARRY OUT          │── 009
   │    DEFORMATION         │
   │    CALCULATION         │
   └────────────┬───────────┘
                │
   ┌────────────────────────┐
   │  EXTRACT OXIDE FILM    │── 010
   │     THICKNESS AT       │
   │  SPECIFIED POSITION    │
   └────────────┬───────────┘
```

- 011  EFFECTIVE OXIDE FILM THICKNESS = SPECIFIED OXIDE FILM THICKNESS?  — YES → END
- NO
- 011  EFFECTIVE OXIDE FILM THICKNESS < SPECIFIED OXIDE FILM THICKNESS?  — YES
- NO
- 013  ΔT = ΔT/2
- 014  LOAD INTERNAL DATA AT TIME t_save
- 015  t_now = t_save
- 016  SAVE INTERNAL DATA AT TIME t_save

# Fig. 2

```
        ┌─────────────┐
        │    START    │
        └──────┬──────┘
               │
    ┌──────────────────┐
    │ SET SPECIFIED    │╱─101
    │ OXIDE FILM       │
    │ THICKNESS        │
    └──────────────────┘
               │
    ┌──────────────────┐
    │     SET Δt       │╱─102
    └──────────────────┘
               │
    ┌──────────────────┐
    │   t_save = 0     │╱─103
    └──────────────────┘
               │
    ┌──────────────────┐
    │    t_now =       │╱─104
    │  t_save + Δt     │
    └──────────────────┘
               │
    ┌──────────────────┐
    │  SOLVE OXIDANT   │
    │ DIFFUSION        │╱─105
    │ EQUATION TO      │
    │ CALCULATE        │
    │ SURFACE OXIDANT  │
    │ CONCENTRATION    │
    └──────────────────┘
               │
    ┌──────────────────┐
    │ CALCULATE        │
    │ EFFECTIVE OXIDE  │╱─106
    │ FILM THICKNESS   │
    │ FROM SURFACE     │
    │ OXIDANT          │
    │ CONCENTRATION    │
    └──────────────────┘
```

Flowchart blocks:

- START
- 101 SET SPECIFIED OXIDE FILM THICKNESS
- 102 SET Δt
- 103 t_save = 0
- 104 t_now = t_save + Δt
- 105 SOLVE OXIDANT DIFFUSION EQUATION TO CALCULATE SURFACE OXIDANT CONCENTRATION
- 106 CALCULATE EFFECTIVE OXIDE FILM THICKNESS FROM SURFACE OXIDANT CONCENTRATION
- 107 EFFECTIVE OXIDE FILM THICKNESS = SPECIFIED OXIDE FILM THICKNESS? — YES / NO
- 108 EFFECTIVE OXIDE FILM THICKNESS < SPECIFIED OXIDE FILM THICKNESS? — YES / NO
- 109 ΔT = ΔT/2
- 110 CALCULATE OXIDE REACTION RATE
- 111 PRODUCE NEW INTERFACE
- 112 CARRY OUT DEFORMATION CALCULATION
- 113 CALCULATE OXIDE REACTION RATE
- 114 PRODUCE NEW INTERFACE
- 115 CARRY OUT DEFORMATION CALCULATION
- END

# Fig. 3

Si3N4

SiO2

Si

Tox_i

Tox_old

Tox_v

# Fig. 4

START

SET SPECIFIED OXIDE FILM THICKNESS — 201

SET Δt — 202

t_save = 0 — 203

SAVE INTERNAL DATA AT TIME t_save — 204

mode = 0 — 205

t_now = t_save + Δt — 206

SOLVE OXIDANT DIFFUSION EQUATION TO CALCULATE SURFACE OXIDANT CONCENTRATION — 207

mode = 0? — 208

NO

YES

CALCULATE EFFECTIVE OXIDE FILM THICKNESS FROM FILM THICKNESS FROM SURFACE OXIDANT CONCENTRATION — 209

EFFECTIVE OXIDE FILM THICKNESS = SPECIFIED OXIDE FILM THICKNESS? — 210

YES

NO

ΔT = ΔT/2 — 211

CALCULATE OXIDE REACTION RATE — 212

PRODUCE NEW INTERFACE — 213

CARRY OUT DEFORMATION CALCULATION — 214

EXTRACT OXIDE FILM THICKNESS AT SPECIFIED POSITION — 215

EFFECTIVE OXIDE FILM THICKNESS = SPECIFIED OXIDE FILM THICKNESS ? — 216

YES

END

NO

EFFECTIVE OXIDE FILM THICKNESS < SPECIFIED OXIDE FILM THICKNESS ? — 217

YES

NO

218 — mode = 1

219 — ΔT = ΔT/2

220 — LOAD INTERNAL DATA AT TIME t_save

t_now = t_save — 221

SAVE INTERNAL DATA AT TIME t_save — 222

# F i g . 5

Si3N4

SiO2

Tox

Si

# Fig. 6

INPUT UNIT — 11

PROCESSOR — 12

— 12-1

DISPLAY UNIT — 13